# EUROPÄISCHE PATENTSCHRIFT

(11) **EP 1 002 912 B1**
(45) Veröffentlichungstag und Bekanntmachung des Hinweises auf die Patenterteilung: **06.07.2005**
(21) Anmeldenummer: 99122377.7
(22) Anmeldetag: 10.11.1999
(51) Int. Cl.: E04C 5/00, H05K 9/00

(54) **Verfahren zur elektrischen Kontaktierung von Betonarmierungen**
Method of making an electrical contact between rebars
Méthode pour réaliser un contact éléctrique entre armatures à béton

(30) Priorität: 19.11.1998 DE 19853332
(43) Veröffentlichungstag der Anmeldung: 24.05.2000
(73) Patentinhaber: Pfeil, Gerhard, 21723 Hollern-Twielenfleth (DE)
(72) Erfinder: Pfeil, Gerhard, 21723 Hollern-Twielenfleth (DE)
(74) Vertreter: Stenger, Watzke & Ring Patentanwälte

(56) Entgegenhaltungen:
- EP-A- 0 291 597
- WO-A-94/04474
- DE-A- 4 103 216
- DE-A- 4 341 329
- FR-A- 2 611 829
- US-A- 2 793 245
- US-A- 4 520 521
- BUNGEY J: "NON-DESTRUCTIVE TESTING FOR REINFORCEMENT CORROSION" CONCRETE,GB,CEMENT AND CONCRETE ASSOCIATION. LONDON, Bd. 27, Nr. 1, 1. Januar 1993 (1993-01-01), Seiten 16-18, XP000336625 ISSN: 0010-5317
- ROWLAND P W: "INDUSTRIAL SYSTEM GROUNDING FOR POWER, STATIC, LIGHTNING AND INSTRUMENTATION, PRACTICAL APPLICATIONS" , IEEE TRANSACTIONS ON INDUSTRY APPLICATIONS,US,IEEE INC. NEW YORK, VOL. 31, NR. 6, PAGE(S) 1I-6I XP000555148 ISSN: 0093-9994 * das ganze Dokument *

## Beschreibung

Die vorliegende Erfindung betrifft ein Verfahren zur elektrischen Kontaktierung von Metallarmierungen in Beton.

Im Betonbau ist es selbstverständlich, daß in dem Beton Metallarmierungen angeordnet sind. Im Rahmen von elektromagnetischen Abschirmmaßnahmen hat es sich als vorteilhaft herausgestellt, die Betonarmierungen elektrisch zu kontaktieren und vorzugsweise zu erden. Derartige Abschirmungen, die beispielsweise in Kernkraftwerken erforderlich sind, stellen Nachrüstmaßnahmen, die zum Teil mit erheblichem Stemmaufwand durchgeführt werden. Im Stand der Technik sind Verfahren zur nachträglichen Herstellung von elektrisch leitenden Verbindungen bekannt, wobei man die Bewährung im Ortbeton durch großflächiges Stemmen freilegt und anschließend mit Klemmverbindungen elektrisch leitfähig an die Betonoberfläche herausführt. In unmittelbarer Nähe an einem anderen Gebäudeteil erfolgt die gleiche Tätigkeit. Danach verbindet man beide herausgeführten Anschlüsse elektrisch leitend. Wenn diese Art der Adaptierung an genügend viel Stellen zwischen den Gebäudeteilen durchgeführt wird, erreicht man damit eine gute Gesamtabschirmung des Gebäudes und der darin befindlichen elektrischen Einbauten nach dem Prinzip des Faradayschen Käfigs. Diese elektrische Verbindung ist insbesondere zur Überbrückung von Gebäudetrenn- und Dehnfugen notwendig.

Aus dem Stand der Technik ist beispielsweise durch die "Non-destructive testing for reinforcement corrosion" in Concrete von Bungey J., Dement and Concrete Association, London, Bd. 27, Nr. 1 ein Verfahren bekannt, mit dem die Korrosion von Metallarmierungen in Beton überprüft werden kann. Dazu wird eine Metallarmierung über zwei voneinander entfernt angeordnete Bohrungen freigelegt und mittels zweier Kontakte kontaktiert. Über die Kontakte wird ein Wechselstrom eingespeist, wobei aus dem Spannungsabfall auf den Zustand der Metallarmierung geschlossen werden kann. In einem weiterentwickelten Verfahren werden zwischen den zwei Bohrungen zwei weitere Bohrungen vorgesehen, über die ein Spannungsmeßgerät mit der Metallarmierung in Kontakt gebracht werden kann. Ein gemessener Spannungsabfall liefert einen Hinweis für den Zustand der Metallarmierung bezüglich der Korrosion.

Aus der FR 2 611 829 A1 ist femer eine Wandverankerung bekannt, bei der ein gewindeloser Spreizdübel mit einem konusförmigen Element aufgeweitet wird. Das konusförmige Element weist hierfür eine Gewindebohrung auf, in die ein Gewindestift eingeführt ist. Durch Drehbetätigung des Gewindestiftes wird das konusförmige Element in die Bohrung des Spreizdübels hineingezogen, welcher sich dadurch aufweitet und eine Verankerung im Mauerwerk herstellt. Femer ist es erforderlich, den Spreizdübel durch ein Gegenlager zur axialen Bewegung durch das Konuselement gegenzulagem, damit dieser bei Betätigung der Gewindestange nicht mit der Bewegung des konusförmigen Elements axial mitbewegt wird.

Ausgehend von diesem Stand der Technik liegt der vorliegenden Erfindung die **Aufgabe** zugrunde, ein Verfahren zur elektrischen Kontaktierung von Metallarmierungen in Beton bereitzustellen, welches mit geringem wirtschaftlichen Aufwand durchführbar ist und insbesondere ein Freistemmen und ein anschließendes Vergießen der Betonfläche vermeidet.

Zur technischen **Lösung** dieser Aufgabe wird mit der Erfindung vorgeschlagen ein Verfahren zur elektrischen Kontaktierung von Metallarmierungen in Beton, wobei die Position der Metallarmierung in Beton festgestellt wird, ein bis zur Metallarmierung verlaufendes Bohrloch im Beton hergestellt wird, im Bohrloch eine Gewindestange mittels eines Spreizdübels verankert und bis zur elektnsch leitenden Kontaktierung mit der Metallarmierung eingeschraubt wird.

Das erfindungsgemäße Verfahren vermeidet ein Aufstemmen durch die Anordnung einer Bohrung, in die ein Spreizdübel gesetzt wird, in welchem wiederum eine Gewindestange eingeführt wird. Die Metallarmierung im Beton wird zunächst unter Verwendung eines Eisensuchgerätes geortet und die Position des Bewährungseisens markiert. Es wird dann ein Bohrloch bis zum Eisen hergestellt. Anschließend wird das Bohrloch mit einem hinterschnittenen Konusbereich hergestellt und vollständig gesäubert. Durch das Bohrloch ist nun die Metallarmierung metallisch frei. Es wird dann in einen Spreizdübel eine Gewindestange eingedreht, bis der Dübel anfängt, sich zu spreizen. Dann wird die Baugruppe in das Bohrloch eingeführt und die Gewindestange in den Spreizdübel eingedreht, bis diese die Metallarmierung kontaktiert. Die Gewindestange ist damit im Bohrloch verankert, kann abgelängt und elektrisch verbunden werden.

Der Dübel ist in vorteilhafterweise ein Metalldübel, der einen sich in Einsatzrichtung verjüngende Innendurchmesser aufweist, um eine entsprechend gute Spreizung zu erzeugen. Außerdem wird durch diese Maßnahme beim Eindrehen der Gewindestange das Gewinde am verjüngtem Bereich zerstört, so daß ein selbständiges Lösen behindert ist.

Unter Gewindestange im Sinne der Erfindung können Gewindeschrauben, Maschinenschrauben oder auch einfache mit Gewinde versehene Metallstangen verstanden werden. Spreizdübel sind vorzugsweise metallische Dübel, die über einen Teil ihrer Länge geschlitzt sind, sich also beim Eindrehen der Gewindestange ausspreizen. Es ist vorteilhaft, beim Eindrehen der Gewindestange den elektrischen Widerstand zu messen.

Je nach Umgebungsbereich kann das Bohrloch vor dem Aufbau der elektrischen Verbindung durch Abspritzen abgedichtet werden, um ein nachträgliches Eindringen von Feuchtigkeit zu verhindern.

Mit der Erfindung wird ein wirtschaftlich durchführbares und einfaches Verfahren zur elektrischen Kontaktierung von Betonarmierungen bereitgestellt. Weiterhin stellt die Erfindung eine Vorrichtung zur elektrischen Kontaktierung von Metallarmierungen in Beton gemäß dem erfindungsgemäßen Verfahren bereit, bestehend aus einem mit einem Innengewinde versehenen Spreizdübel mit sich in Einsatzrichtung verjüngendem Innendurchmesser und einer metallischen Gewindestange mit im wesentlichen konstantem Durchmesser, wobei mittels der Gewindestange der elektrische Kontakt zur Metallarmierung herstellbar ist.

Weitere Vorteile und Merkmale der Erfindung ergeben sich aus der folgenden Beschreibung anhand der Figuren. Dabei zeigen:
- Fig. 1: eine schematische Darstellung eines metallarmierten Betonbereiches mit unterschiedlichen Verfahrenssituationen und
- Fig. 2: eine Darstellung eines Ausführungsbeispiels für einen Spreizdübel.

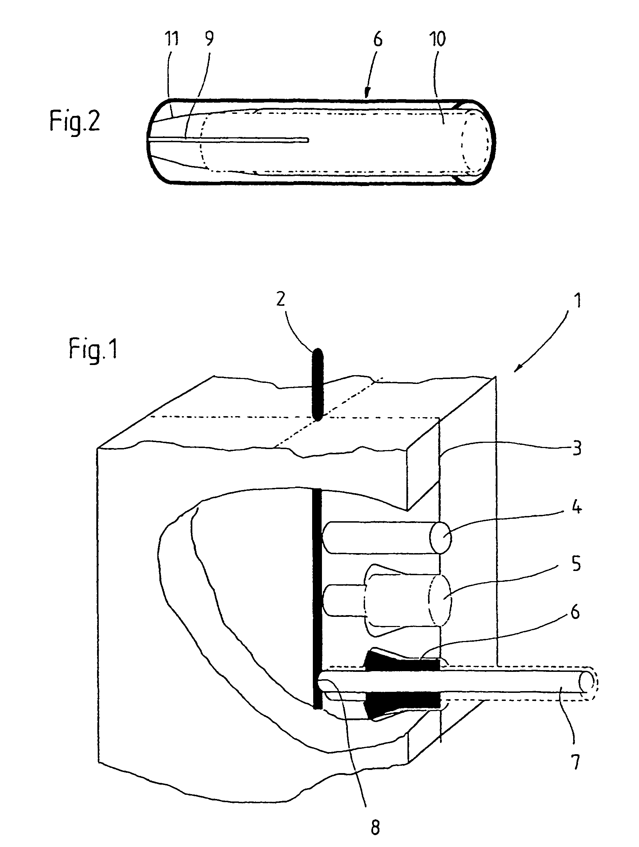

Figur 1 zeigt einen schematischen Betonbereich 1, in den eine Metallarmierung 2 geführt ist. Zunächst wird mit einem Eisensuchgerät auf der Betonoberfläche geortet, bis die Metallarmierung gefunden wurde, um die Position des Bewährungseisens mit einer Markierung 3 versehen. Es wird dann ein Bohrloch 4 hergestellt, welches bis auf die Bewährung reicht und beispielsweise einen Durchmesser von 8 mm hat. Anschließend wird mit einem größeren Bohrer, beispielsweise 10 mm, eine Bohrung 5 mit hinterschnittenem Konus hergestellt und die Bohrung anschließend gesäubert.

Als Dübel kommen in Betracht Metalldübel, beispeilsweise mit einem Außendurchmesser von 10 mm und einer Mindestlänge von 25 mm. Als Metall kommen vorzugsweise Eisen und dessen Legierungen und Messing und dessen Legierungen in Frage. Im Inneren weist der Dübel beispielsweise ein M8-Gewinde auf und hat mindestens 3 regelmäßig über den Umfang verteilte, maximal jedoch 8 regelmäßig über den Umfang verteilte Einschnitte von etwa 1,4 mm. Das Gewinde ist beispielsweise konisch auslaufend und ragt mindestens 6 mm in die durch die Einschnitte gebildeten Segmente hinein. Die Segmentstärke am Ende des Dübels beträgt mindestens 2 mm, maximal 2,8 mm. Ein Ausführungsbeispiel für ein Dübel ist in Figur 2 gezeigt, wo der Dübel 6 einen langen Gewindebereich 10 mit gleichmäßigem Durchmesser und einen verjüngten Durchmesserbereich 11 aufweist, der im Bereich der Einschnitte 9 liegt.

Ein solcher Dübel wird mit einer Gewindestange verbunden. Die Gewindeschraube, Maschinenschraube oder Gewindestange 7 wird in den Dübel 6 eingeschraubt, bis dieser beginnt, sich im vorderen Bereich zu spreizen. Anschließend wird die Baugruppe ins Bohrloch 5 gesteckt und die Gewindestange in den Dübel gedreht. Gleichzeitig wird mit einem Widerstandsmessgerät, einem nicht gezeigten Ω-Meter, der Widerstand zwischen einer vorhandenen Potentialschiene beziehungsweise geeigneter Masse und der Gewindestange beziehungsweise Maschinenschraube gemessen. Sobald der Widerstandwert geringe Ohmwerte, beispielsweise kleiner 10 Ohm annimmt, wird die Gewindestange beziehungsweise Maschinenschraube soweit weiter gedreht wie möglich, und zwar manuell und ohne Hilfsmittel, um das Gewinde nicht zu überdrehen oder sonstige Elemente zu beschädigen. Es kann dann mit konventionellen Mitteln die Gewindestange abgelängt und elektrisch kontaktiert werden, beispielsweise durch Muttern, Kabelschuhe , Sicherungsscheiben und dergleichen. Die im Bereich 8 die Bewährung kontaktierende Gewindestange 7 stellt nunmehr die elektrische Verbindung her.

Je nach Umgebungsbereich, in dem zum Beispiel über Feuchtigkeit eine Beeinträchtigung der Bewährung zu erwarten ist, beispielsweise durch Korrosion, ist das Bohrloch vor dem Aufbau der elektrischen Verbindung durch Abspritzen mit zugelassenen Materialien abzudichten.

Die beschriebenen Ausführungsbeispiele dienen nur der Erläuterung und sind nicht beschränkend.

### Bezugszeichenliste

- 1: Beton
- 2: Bewährung
- 3: Markierung
- 4: Bohrung
- 5: erweiterte Bohrung
- 6: Spreizdübel
- 7: Gewindestange
- 8: Kontaktbereich
- 9: Einschnitt
- 10: Gewindebereich
- 11: Verjüngung

## Patentansprüche

1. Verfahren zur elektrischen Kontaktierung von Metallarmierungen in Beton, wobei
- die Position der Metallarmierung in Beton festgestellt wird,
- ein bis zur Metallarmierung verlaufendes Bohrloch im Beton hergestellt wird,
- im Bohrloch eine Gewindestange mittels eines Spreizdübels verankert und
- bis zur elektrisch leitenden Kontaktierung mit der Metallarmierung eingeschraubt wird.

2. Verfahren nach Anspruch 1, **dadurch gekennzeichnet, daß** ein Spreizdübel mit Innengewinde verwendet wird

3. Verfahren nach einem der vorhergehenden Ansprüche, **dadurch gekennzeichnet, daß** ein Spreizdübel mit in Einsatzrichtung sich verjüngendem Innendurchmesser verwendet wird.

4. Verfahren nach einem der vorgehenden Ansprüche, **dadurch gekennzeichnet, daß** ein aus metallischem Werkstoff bestehender Spreizdübel verwendet wird.

5. Verfahren nach einem der vorhergehenden Ansprüche, **dadurch gekennzeichnet, daß** das Bohrloch mit einem in Richtung der Metallarmierung hinterschnittenen Erweiterungsbereich ausgebildet wird.

6. Verfahren nach Anspruch 5, **dadurch gekennzeichnet, daß** der Erweiterungsbereich konisch ausgeführt wird.

7. Verfahren nach einem der vorhergehenden Ansprüche, **dadurch gekennzeichnet, daß** bei der Herstellung der elektrisch leitenden Kontaktierung eine Widerstandsmessung durchgeführt wird.

8. Verfahren nach einem der vorhergehenden Ansprüche, **dadurch gekennzeichnet, daß** das Bohrloch feuchtigkeitsdicht abgedichtet wird.

9. Verfahren nach einem der vorgehenden Ansprüche, **dadurch gekennzeichnet, daß** die Gewindestangen außerhalb des Bohrloches elektrisch angeschlossen wird.

10. Vorrichtung zur elektrischen Kontaktierung von Metallarmierungen in Beton nach dem Verfahren nach einem der Ansprüche 1 bis 9, bestehend aus einem mit einem Innengewinde versehenen Spreizdübel mit sich in Einsatzrichtung verjüngendem Innendurchmesser und einer metallischen Gewindestange mit im wesentlichen konstantem Durchmesser, wobei mittels der Gewindestange der elektrische Kontakt zur Metallarmierung herstellbar ist.

## Claims

1. Method of electrical contacting of metal reinforcements in concrete, wherein
- the position of the metal reinforcement in concrete is established,
- a bore which extends as far as the metal reinforcement is produced in the concrete,
- a threaded rod is anchored in the bore by means of an expanding dowel, and
- is screwed in until it makes electrically conductive contact with the metal reinforcement.

2. Method as claimed m Claim 1, **characterised in that** an expanding dowel with an internal thread is used.

3. Method as claimed m any one of the preceding claims, **characterised in that** an expanding dowel is used which has an internal diameter tapering in the direction of insertion.

4. Method as claimed in any one of the preceding claims, **characterised in that** an expanding dowel made from a metal material is used.

5. Method as claimed in any one of the preceding claims, **characterised in that** the bore is constructed with an expansion region which is undercut in the direction of the metal reinforcement.

6. Method as claimed in Claim 5, **characterised in that** the expansion region is of conical construction.

7. Method as claimed in any one of the preceding claims, **characterised in that** a measurement of resistance is carried out during the production of the electrically conductive contact.

8. Method as claimed in any one of the preceding claims, **characterised in that** the bore is sealed so as to be moisture-proof.

9. Method as claimed in any one of the preceding claims, **characterised in that** the threaded rods are electrically connected outside the bore.

10. Device for electric contacting of metal reinforcements in concrete according to the method as claimed in any one of Claims 1 to 9, comprising an expanding dowel provided with an internal thread with an internal diameter tapering in the direction of insertion and a metal threaded rod with a substantially constant diameter, wherein the electrical contact with the metal reinforcement can be made by means of the threaded rod.

## Revendications

1. Procédé de mise en contact électrique des armatures métalliques dans le béton, avec
- détermination de la position de l'armature métallique dans le béton,
- forage d'un trou dans le béton jusqu'à l'armature métallique,
- ancrage d'une tige filetée dans la forure au moyen d'une cheville expansible et
- vissage de la tige filetée dans la forure jusqu'à ce que le contact électroconducteur soit établi avec l'armature métallique.

2. Procédé selon la revendication 1, **caractérisé en ce que** l'on utilise une cheville expansible présentant un taraudage.

3. Procédé selon l'une quelconque des revendications précédentes, **caractérisé en ce que** l'on utilise une cheville expansible ayant un diamètre intérieur se rétrécissant dans la direction d'introduction.

4. Procédé selon l'une quelconque des revendications précédentes, **caractérisé en ce que** l'on utilise une cheville expansible réalisée dans un matériau métallique.

5. Processus selon l'une quelconque des revendications précédentes, **caractérisé en ce que** la forure est réalisée avec une zone élargie présentant une contre-dépouille en direction de l'armature métallique.

6. Procédé selon la revendication 5, **caractérisé en ce que** la zone élargie est conique.

7. Procédé selon l'une quelconque des revendications précédentes, **caractérisé en ce qu'**une mesure de résistance est effectuée au moment de l'établissement du contact électroconducteur.

8. Procédé selon l'une quelconque des revendications précédentes, **caractérisé en ce que** la forure est rendue étanche contre l'humidité.

9. Procédé selon l'une quelconque des revendications précédentes, **caractérisé en ce que** les tiges filetées sont raccordées électriquement en dehors de la forure.

10. Dispositif de mise en contact électrique d'armatures métalliques dans le béton selon le procédé selon l'une quelconque des revendications 1 à 9, formé par une cheville expansible présentant un taraudage et ayant un diamètre intérieur se rétrécissant dans la direction d'introduction et par une tige filetée métallique ayant un diamètre sensiblement constant, le contact électrique avec l'armature métallique pouvant être établi au moyen de la tige filetée.
